# EUROPEAN PATENT APPLICATION

(11) **EP 4 557 905 A1**
(43) Date of publication of application: **21.05.2025**
(21) Application number: 24186205.1
(22) Date of filing: 03.07.2024
(51) Int. Cl.: H10B 12/00

(54) **SEMICONDUCTOR DEVICE**

(30) Priority: 15.11.2023 KR 20230158123
(71) Applicant: Samsung Electronics Co., Ltd., Suwon-si, Gyeonggi-do 16677 (KR)
(72) Inventor: KWON, Donghoon, 16677 Suwon-si, Gyeonggi-do (KR); PARK, Jonghyuk, 16677 Suwon-si, Gyeonggi-do (KR)
(74) Representative: Kuhnen & Wacker Patent- und Rechtsanwaltsbüro PartG mbB

(57) **Abstract**

A semiconductor device includes an active pattern, a gate structure that extends in a first direction on the active pattern, a bit line electrically connected to the active pattern and extending in a second direction, a gate contact electrically connected to the gate structure, a dummy line between the gate contact and the bit line, and a dummy dielectric layer at least partially surrounded by the dummy line, where the dummy line includes: a first dummy line part between the dummy dielectric layer and the bit line, a second dummy line part spaced apart from the first dummy line part, and a plurality of connection parts that electrically connect the first and second dummy line parts to each other, and where the dummy dielectric layer is between the first dummy line part and the second dummy line part and is between the plurality of connection parts.

## Description

### CROSS-REFERENCE TO RELATED APPLICATION

This U.S. nonprovisional application claims priority under 35 U.S.C. §119 to Korean Patent Application No. 10-2023-0158123 filed on November 15, 2023 in the Korean Intellectual Property Office, the disclosure of which is hereby incorporated by reference in its entirety.

### TECHNICAL FIELD

The present disclosure relate to a semiconductor device, and more particularly, to a semiconductor device including a dummy line.

### BACKGROUND

A semiconductor device attracts attention as a desired element in the electronic industry because of its properties, such as compactness, multi-functionality, and/or low manufacturing cost. Semiconductor devices may encompass semiconductor memory devices storing logic data, semiconductor logic devices processing operations of logic data, and hybrid semiconductor devices having both memory and logic elements.

Recently, due to high speed and low consumption of electronic products, it may be desirable for semiconductor devices embedded in the electronic products to have high operating speed and/or lower operating voltage. However, an increase in integration of semiconductor devices may cause a reduction in electrical properties and production yield of semiconductor devices. Therefore, many studies have been conducted to increase electrical properties and production yield of semiconductor devices.

### SUMMARY

Some embodiments of the present disclosure provide a semiconductor device with increased reliability and improved electrical properties.

According to some embodiments of the present disclosure, a semiconductor device may comprise: an active pattern, a gate structure that extends in a first direction on the active pattern, a bit line electrically connected to the active pattern and extends in a second direction that intersects the first direction, a gate contact electrically connected to the gate structure, a dummy line between the gate contact and the bit line, and a dummy dielectric layer at least partially surrounded by the dummy line, where the dummy line includes: a first dummy line part between the dummy dielectric layer and the bit line, a second dummy line part spaced apart from the first dummy line part, and a plurality of connection parts that electrically connect the first and second dummy line parts to each other, and where the dummy dielectric layer is between the first dummy line part and the second dummy line part and is between the plurality of connection parts.

According to some embodiments of the present disclosure, a semiconductor device may comprise: a substrate that includes a cell region, a peripheral region at least partially surrounding the cell region, and an interface region between the cell region and the peripheral region, an active pattern on the substrate, a gate structure on the active pattern, a bit line electrically connected to the active pattern, a dummy line on the interface region, a first outer dummy spacer that contacts a first outer sidewall of the dummy line, a second outer dummy spacer that contacts a second outer sidewall of the dummy line, and an inner dummy spacer that contacts inner sidewalls of the dummy line, where the inner dummy spacer is between the first outer dummy spacer and the second outer dummy spacer.

According to some embodiments of the present disclosure, a semiconductor device may comprise: a substrate, an active pattern on the substrate, a device isolation layer that at least partially surrounds the active pattern, a gate structure that extends in a first direction on the active pattern, a dielectric pattern and a dummy dielectric pattern that are on the gate structure, a bit line that extends in a second direction on the dielectric pattern, the second direction intersecting the first direction, a gate contact electrically connected to the gate structure, a dummy line on the dummy dielectric pattern and between the gate contact and the bit line, a bit-line contact that electrically connects the bit line and the active pattern to each other, a node contact electrically connected to the active pattern, a landing pad electrically connected to the node contact, an inner dummy spacer at least partially surrounded by the dummy line, and a dummy dielectric layer at least partially surrounded by the inner dummy spacer, where a bottom surface of the inner dummy spacer contacts a top surface of the dummy dielectric pattern, and where the dummy dielectric layer extends into the dummy dielectric pattern and contacts the gate structure.

### BRIEF DESCRIPTION OF DRAWINGS

FIG. 1A illustrates a simplified plan view showing a semiconductor device according to some embodiments.
FIG. 1B illustrates an enlarged view showing section E1 of FIG. 1A.
FIG. 1C illustrates a cross-sectional view taken along line A-A' of FIG. 1B.
FIG. 1D illustrates a cross-sectional view taken along line B-B' of FIG. 1B.
FIG. 1E illustrates a cross-sectional view taken along line C-C' of FIG. 1B.
FIG. 1F illustrates a cross-sectional view taken along line D-D' of FIG. 1B.
FIG. 1G illustrates an enlarged view showing section E2 of FIG. 1B.
FIGS. 2A, 2B, 2C, 2D, 2E, 3A, 3B, 3C, 3D, 4A, 4B, 4C, 5A, 5B, and 5C illustrate diagrams showing a method of fabricating a semiconductor device according to FIGS. 1A to 1G.
FIG. 6 illustrates an enlarged plan view showing a semiconductor device according to some embodiments.
FIG. 7 illustrates a plan view showing a method of fabricating a semiconductor device according to some embodiments.
FIG. 8 illustrates a plan view showing a method of fabricating a semiconductor device according to some embodiments.
FIG. 9 illustrates a plan view showing a method of fabricating a semiconductor device according to some embodiments.
FIG. 10 illustrates a plan view showing a method of fabricating a semiconductor device according to some embodiments.
FIG. 11 illustrates a plan view showing a method of fabricating a semiconductor device according to some embodiments.
FIG. 12 illustrates a plan view showing a method of fabricating a semiconductor device according to some embodiments.
FIG. 13 illustrates a plan view showing a method of fabricating a semiconductor device according to some embodiments.
FIG. 14 illustrates a plan view showing a method of fabricating a semiconductor device according to some embodiments.
FIG. 15 illustrates a plan view showing a method of fabricating a semiconductor device according to some embodiments.

### DETAILED DESCRIPTION

The following will describe a semiconductor device and a method of fabricating the same according to some embodiments of the present disclosure in conjunction with the accompanying drawings.

To clarify the present disclosure, parts that are not connected with the description will be omitted, and the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the phrase "at least one of A, B, and C" refers to a logical (A OR B OR C) using a non-exclusive logical OR, and should not be construed to mean "at least one of A, at least one of B and at least one of C." As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof. The term "and/or" includes any and all combinations of one or more of the associated listed items. The term "connected" may be used herein to refer to a physical and/or electrical connection and may refer to a direct or indirect physical and/or electrical connection. Components or layers described with reference to "overlap" in a particular direction may be at least partially obstructed by one another when viewed along a line extending in the particular direction or in a plane perpendicular to the particular direction.

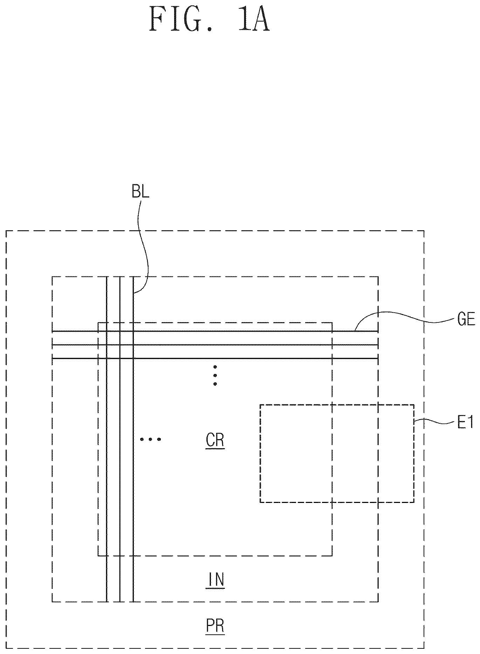

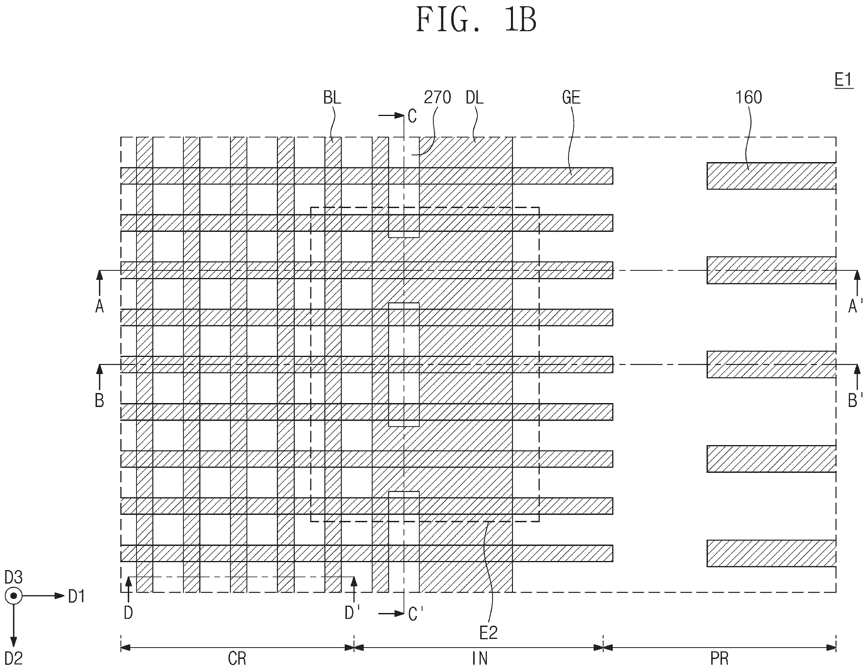

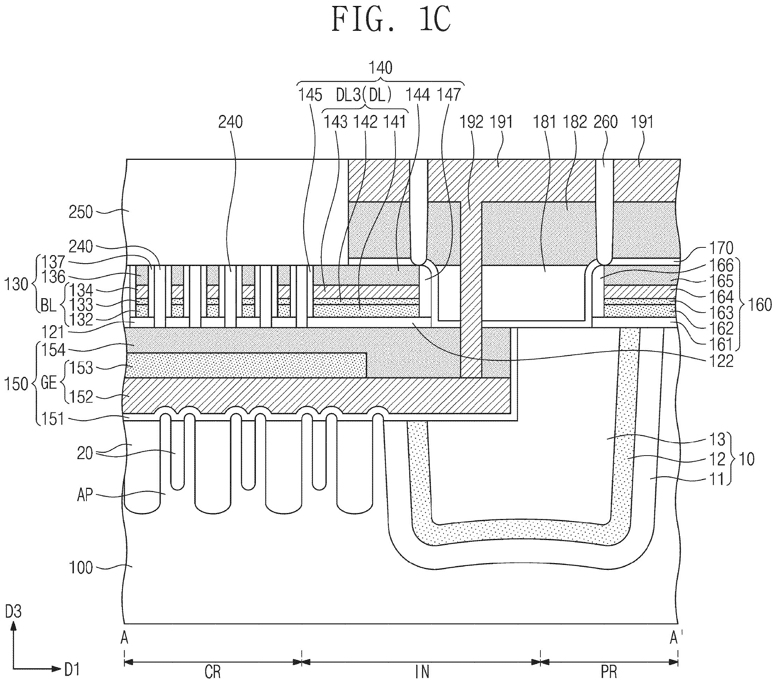

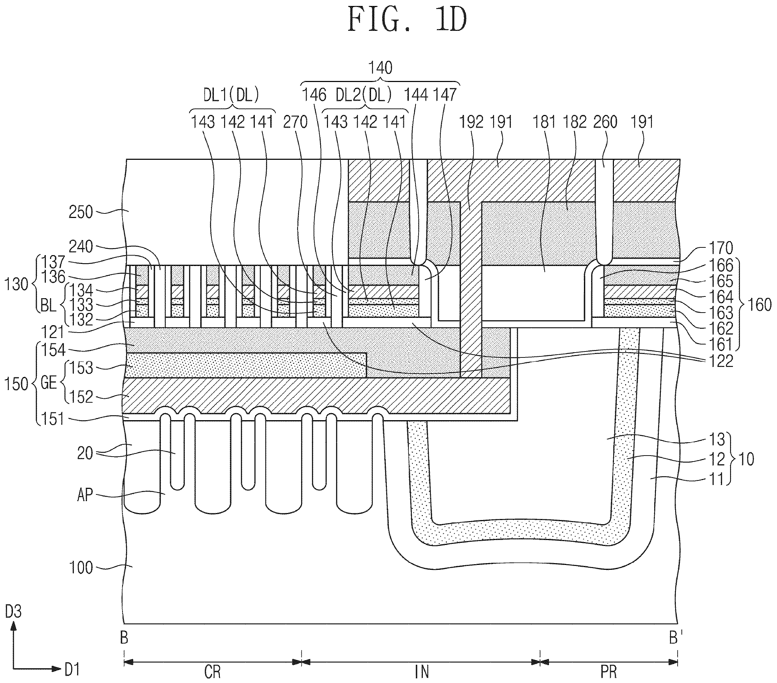

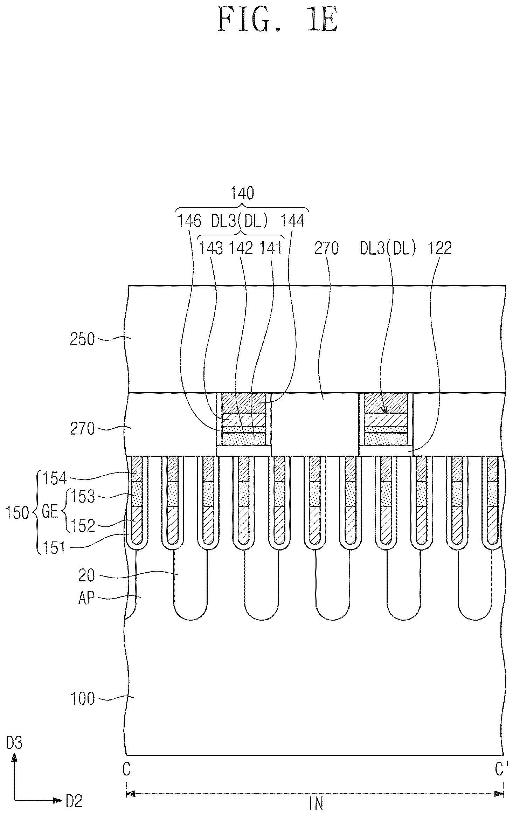

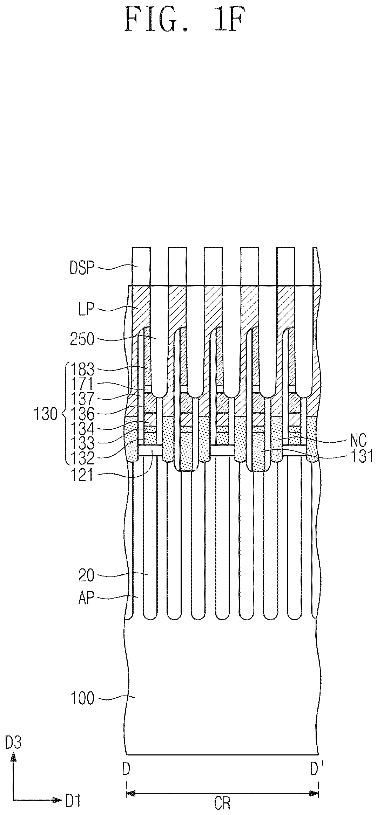

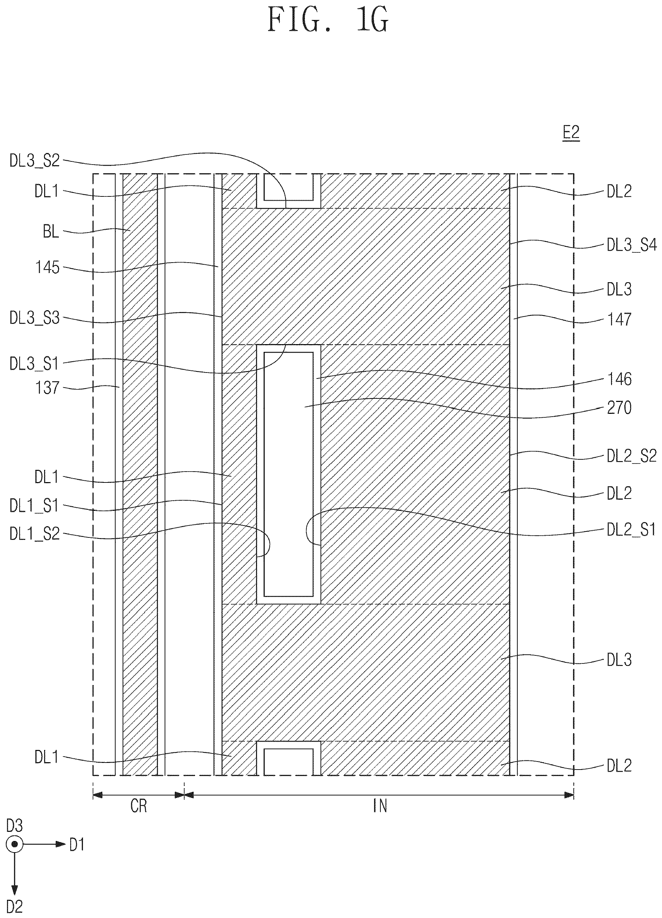

FIG. 1A illustrates a simplified plan view showing a semiconductor device according to some embodiments. FIG. 1B illustrates an enlarged view showing section E1 of FIG. 1A. FIG. 1C illustrates a cross-sectional view taken along line A-A' of FIG. 1B. FIG. 1D illustrates a cross-sectional view taken along line B-B' of FIG. 1B. FIG. 1E illustrates a cross-sectional view taken along line C-C' of FIG. 1B. FIG. 1F illustrates a cross-sectional view taken along line D-D' of FIG. 1B. FIG. 1G illustrates an enlarged view showing section E2 of FIG. 1B.

Referring to FIGS. 1A, 1B, 1C, 1D, 1E, and 1F, a semiconductor device may include a substrate 100. The substrate 100 may be a semiconductor substrate, a dielectric substrate, a silicon-on-insulator (SOI) substrate, or a germanium-on-insulator (GOI) substrate. The semiconductor substrate may include, for example, silicon (Si), germanium (Ge), silicon-germanium (SiGe), gallium phosphate (GaP), or gallium arsenide (GaAs). The substrate 100 may have a plate shape that extends along a plane elongated in a first direction D1 and a second direction D2. The first direction D1 and the second direction D2 may intersect each other. For example, the first direction D1 and the second direction D2 may be horizontal directions that are orthogonal to each other.

The substrate 100 may include a cell region CR, a peripheral region PR that at least partially surrounds the cell region CR, and an interface region IN between the cell region CR and the peripheral region PR. The cell region CR, the interface region IN, and the peripheral region PR may be distinguished when viewed on a plane defined by the first direction D1 and the second direction D2. The peripheral region PR may be provided thereon with sense amplifiers and sub-word line drivers that overlap each other in a third direction D3.

The substrate 100 may be provided thereon with active patterns AP. The active patterns AP may overlap in the third direction D3 with the cell region CR and the interface region IN. The third direction D3 may intersect the first direction D1 and the second direction D2. For example, the third direction D3 may be a vertical direction perpendicular to the first direction D1 and the second direction D2. The active pattern AP may extend in a direction that intersects the first direction D1 and the second direction D2. The active pattern AP may be included in the substrate 100. The active patterns AP may be defined to refer to upper portions of the substrate 100 that protrude or extend in the third direction D3.

A device isolation layer 20 may be provided to define the active patterns AP. The active patterns AP may be at least partially surrounded by the device isolation layer 20.

A dielectric structure 10 may be provided in the substrate 100. The dielectric structure 10 may be provided between the interface region IN and the peripheral region PR. In some embodiments, the dielectric structure 10 and the device isolation layer 20 may be connected to have a single unitary structure with no boundary therebetween.

The device isolation layer 20 may include a dielectric material. For example, the device isolation layer 20 may include one or more of oxide and nitride. The dielectric structure 10 may include a first dielectric layer 11, a second dielectric layer 12 on the first dielectric layer 11, and a third dielectric layer 13 on the second dielectric layer 12. For example, the first dielectric layer 11 may include oxide, the second dielectric layer 12 may include nitride, and the third dielectric layer 13 may include oxide.

Gate structures 150 may be provided which extend in the first direction D1. The gate structures 150 may be spaced apart from each other in the second direction D2. The gate structure 150 may overlap in the third direction D3 with the cell region CR and the interface region IN of the substrate 100. The gate structure 150 may be provided on the device isolation layer 20, the dielectric structure 10, and the active patterns AP.

The gate structure 150 may be a buried gate structure that is buried in the device isolation layer 20, the dielectric structure 10, and the active patterns AP. The gate structure 150 and the active pattern AP may define a cell transistor.

The gate structure 150 may include a gate dielectric layer 151 on the active patterns AP, a gate electrode GE on the gate dielectric layer 151, and a gate capping layer 154 on the gate electrode GE. The gate electrode GE may include a first gate conductive layer 152 on the gate dielectric layer 151 and a second gate conductive layer 153 on the first gate conductive layer 152.

The gate dielectric layer 151 and the gate capping layer 154 may include a dielectric material. For example, the gate dielectric layer 151 may include oxide, and the gate capping layer 154 may include nitride.

The first and second gate conductive layers 152 and 153 may include a conductive material. For example, the first gate conductive layer 152 may include titanium nitride, and the second gate conductive layer 153 may include polysilicon.

Dielectric patterns 121 and a dummy dielectric pattern 122 may be provided on the gate capping layer 154 of the gate structure 150. The dielectric patterns 121 may overlap in the third direction D3 with the cell region CR. The dummy dielectric pattern 122 may overlap in the third direction D3 with the interface region IN. The dielectric pattern 121 and the dummy dielectric pattern 122 may be located at the same level. The dielectric pattern 121 and the dummy dielectric pattern 122 may have their top surfaces located at the same level. The dielectric pattern 121 and the dummy dielectric pattern 122 may include a dielectric material. In some embodiments, each of the dielectric pattern 121 and the dummy dielectric pattern 122 may include a plurality of dielectric layers.

Bit-line structures 130 may be provided which extend in the second direction D2. The bit-line structures 130 may be arranged in the first direction D1. The bit-line structure 130 may overlap in the third direction D3 with the cell region CR of the substrate 100. The bit-line structure 130 may be provided on the dielectric pattern 121 and the active pattern AP. The bit-line structure 130 may be in contact with the top surface of the dielectric pattern 121. The bit-line structure 130 may be electrically connected to the active pattern AP.

The bit-line structure 130 may include bit-line contacts 131, a bit line BL, a first bit-line capping layer 136, a second bit-line capping layer 171, a third bit-line capping layer 183, and a bit-line spacer 137. The bit line BL may include first conductive layers 132, a second conductive layer 133, and a third conductive layer 134. A bottom surface of the bit line BL may be in contact with the top surface of the dielectric pattern 121.

The bit-line contacts 131 of one bit-line structure 130 may be arranged in the second direction D2. The first conductive layers 132 of one bit-line structure 130 may be arranged in the second direction D2. The bit-line contacts 131 and the first conductive layers 132 of one bit-line structure 130 may be alternately arranged along the second direction D2. The bit-line contact 131 may be disposed on the active pattern AP. The bit-line contact 131 may electrically connect the active pattern AP and the bit line BL to each other. The bit-line contact 131 may be disposed between the dielectric patterns 121. A bottom surface of the first conductive layer 132 may be in contact with the top surface of the dielectric pattern 121. The bit-line contact 131 and the first conductive layer 132 may include a conductive material. For example, the bit-line contact 131 and the first conductive layer 132 may include polysilicon. In some embodiments, the bit-line contacts 131 and the first conductive layers 132 included in one bit-line structure 130 may be connected without any boundary to have a single unitary structure.

The second conductive layer 133 may be provided on the bit-line contacts 131 and the first conductive layers 132. The third conductive layer 134 may be provided on the second conductive layer 133. The first bit-line capping layer 136 may be provided on the third conductive layer 134. The second bit-line capping layer 171 may be provided on the first bit-line capping layer 136. The third bit-line capping layer 183 may be provided on the second bit-line capping layer 171.

The second conductive layer 133 and the third conductive layer 134 may include a conductive material. For example, the second conductive layer 133 may include polysilicon, and the third conductive layer 134 may include metal. The first, second, and third bit-line capping layers 136, 171, and 183 may include a dielectric material.

The number of conductive layers included in one bit line BL may not be limited to that shown in the drawings. In some embodiments, the number of conductive layers included in one bit line BL may be equal to or less than 2 or may be equal to or greater than 4. In some embodiments, each of the first, second, and third bit-line capping layers 136, 171, and 183 may include a plurality of dielectric layers.

The bit-line spacer 137 may be in contact with sidewalls of the first, second, and third bit-line capping layers 136, 171, and 183, sidewalls of the first, second, and third conductive layers 132, 133, and 134, and sidewalls of the bit-line contacts 131. The bit-line spacer 137 may include a dielectric material. In some embodiments, the bit-line spacer 137 may include a plurality of dielectric layers.

A dummy line structure 140 may be provided. The dummy line structure 140 may overlap in the third direction D3 with the interface region IN of the substrate 100. The dummy line structure 140 may be provided on the dummy dielectric pattern 122. The dummy line structure 140 may be in contact with the top surface of the dummy dielectric pattern 122.

The dummy line structure 140 may include a dummy line DL, a dummy line capping layer 144, a first outer dummy spacer 145, a second outer dummy spacer 147, and an inner dummy spacer 146. The dummy line DL may include a first dummy conductive layer 141, a second dummy conductive layer 142, and a third dummy conductive layer 143. A bottom surface of the dummy line DL may be in contact with the top surface of the dummy dielectric pattern 122.

A bottom surface of the first dummy conductive layer 141 may be in contact with the top surface of the dummy dielectric pattern 122. The first dummy conductive layer 141 may include the same conductive material as that of the first conductive layer 132. For example, the first dummy conductive layer 141 may include polysilicon.

The second dummy conductive layer 142 may be provided on the first dummy conductive layer 141. The third dummy conductive layer 143 may be provided on the second dummy conductive layer 142. The dummy line capping layer 144 may be provided on the third dummy conductive layer 143. The second dummy conductive layer 142 may include the same conductive material as that of the second conductive layer 133. For example, the second dummy conductive layer 142 may include polysilicon. The third dummy conductive layer 143 may include the same conductive material as that of the third conductive layer 134. For example, the third dummy conductive layer 143 may include metal. The dummy line capping layer 144 may include the same dielectric material as that of the first bit-line capping layer 136.

The number of dummy conductive layers included in the dummy line DL may not be limited to that shown. In some embodiments, the number of dummy conductive layers included in the dummy line DL may be equal to or less than 2 or may be equal to greater than 4. In some embodiments, the dummy line capping layer 144 may include a plurality of dielectric layers.

The bit line BL and the dummy line DL may be located at the same level. The bottom surface of the bit line BL may be located at the same level as that of that of the dummy line DL. The first conductive layer 132 and the first dummy conductive layer 141 may be located at the same level. The second conductive layer 133 and the second dummy conductive layer 142 may be located at the same level. The third conductive layer 134 and the third dummy conductive layer 143 may be located at the same level.

The first outer dummy spacer 145 may be adjacent to the bit line BL of the bit-line structure 130. The first outer dummy spacer 145 may be in contact with first outer sidewalls of the first, second, and third dummy conductive layers 141, 142, and 143. The first outer sidewalls of the first, second, and third dummy conductive layers 141, 142, and 143 may be adjacent to the bit line BL of the bit-line structure 130.

The second outer dummy spacer 147 may be opposite to the first outer dummy spacer 145. The second outer dummy spacer 147 may be in contact with second outer sidewalls of the first, second, and third dummy conductive layers 141, 142, and 143. The second outer sidewalls of the first, second, and third dummy conductive layers 141, 142, and 143 may be opposite to the first outer side walls of the first, second, and third dummy conductive layers 141, 142, and 143.

The inner dummy spacer 146 may be at least partially surrounded by the first, second, and third dummy conductive layers 141, 142, and 143. The inner dummy spacer 146 may be in contact with inner sidewalls of the first, second, and third dummy conductive layers 141, 142, and 143. The inner sidewalls of the first, second, and third dummy conductive layers 141, 142, and 143 may be disposed between the first outer sidewalls and the second outer sidewalls of the first, second, and third dummy conductive layers 141, 142, and 143.

The first outer dummy spacer 145, the second outer dummy spacer 147, and the inner dummy spacer 146 may have their bottom surfaces in contact with the top surface of the dummy dielectric pattern 122.

In some embodiments, each of the first outer dummy spacer 145, the second outer dummy spacer 147, and the inner dummy spacer 146 may include a plurality of dielectric layers.

Node contacts NC may be provided. The node contact NC may be provided on the active pattern AP. The node contact NC may be electrically connected to the active pattern AP. The node contact NC may be provided between the bit-line structures 130 that are adjacent to each other in the first direction D1 or between the bit-line structure 130 and the dummy line structure 140 that are adjacent to each other in the first direction D1. The node contact NC may include a conductive material. For example, the node contact NC may include polysilicon.

Landing pads LP may be provided. The landing pad LP may be provided on the node contact NC. The landing pad LP may be electrically connected to the node contact NC. The landing pad LP may include a conductive material. For example, the landing pad LP may include metal. In some embodiments, a metal silicide layer may be provided between the node contact NC and the landing pad LP. In some embodiments, a barrier layer may be provided between the node contact NC and the landing pad LP.

Dielectric fences 240 may be provided. The dielectric fence 240 may be provided on the gate capping layer 154 of the gate structure 150. The dielectric fence 240 may be in contact with the gate capping layer 154 of the gate structure 150. The dielectric fence 240 may be provided between the node contacts NC that are adjacent to each other in the second direction D2. The dielectric fence 240 may be provided between the bit-line structures 130 that are adjacent to each other in the first direction D1 or between the bit-line structure 130 and the dummy line structure 140 that are adjacent to each other in the first direction D1. The dielectric fence 240 may be disposed between the dielectric patterns 121 that are adjacent to each other in the first direction D1 or between the dielectric pattern 121 and the dummy dielectric pattern 122 that are adjacent to each other in the first direction D1. The dielectric fence 240 may include a dielectric material. In some embodiments, the dielectric fence 240 may include a plurality of dielectric layers.

Dummy dielectric layers 270 may be provided. The dummy dielectric layers 270 may be at least partially surrounded by the dummy line structure 140 and the dummy dielectric pattern 122. The dummy line DL and the dummy line capping layer 144 may at least partially surround the dummy dielectric layers 270 and the inner dummy spacers 146. The dummy dielectric layers 270 may penetrate or extend into the dummy line structure 140 and the dummy dielectric pattern 122. The dummy dielectric layers 270 may be spaced apart from each other in the second direction D2. The dummy dielectric layer 270 may include the same dielectric material as that of the dielectric fence 240. In some embodiments, the dummy dielectric layer 270 may include a plurality of dielectric layers.

The dummy dielectric layer 270 may include a different dielectric material from those of the first outer dummy spacer 145, the second outer dummy spacer 147, and the inner dummy spacer 146. The dummy dielectric layer 270 may be provided on the gate capping layer 154 of the gate structure 150. The dummy dielectric layer 270 may be in contact with the gate capping layer 154 of the gate structure 150. The dummy dielectric layer 270 may overlap in the third direction D3 with a plurality of gate structures 150.

A first separation structure 250 may be provided on the dielectric fences 240 and the dummy dielectric layer 270. The first separation structure 250 may separate the landing pads LP from each other. The first separation structure 250 may at least partially surround the landing pad LP. The first separation structure 250 may include a dielectric material.

Data storage patterns DSP may be provided. The data storage pattern DSP may be electrically connected to the active pattern AP through the landing pad LP and the storage node contact BC. In some embodiments, each of the data storage patterns DSP may be a capacitor including a bottom electrode, a dielectric layer, and a top electrode. In this case, the semiconductor device including the data storage patterns DSP may be a dynamic random access memory (DRAM). In some embodiments, each of the data storage patterns DSP may include a magnetic tunnel junction pattern. In this case, the semiconductor device including the data storage patterns DSP may be a magnetic random access memory (MRAM). In some embodiments, the data storage patterns DSP may include a phase change material or a variable resistance material. In this case, the semiconductor device including the data storage patterns DSP may be a phase change random access memory (PRAM) or a resistive random access memory (ReRAM). In some embodiments, each of the data storage patterns DSP may include various materials and/or structures capable of storage data.

Peripheral gate structures 160 may be provided which overlap in the third direction D3 with the peripheral region PR of the substrate 100. In some embodiments, the peripheral gate structure 160 may be a gate of a transistor that constitutes a sub-word line driver.

The peripheral gate structure 160 may include a peripheral dielectric layer 161, a first peripheral conductive layer 162 on the peripheral dielectric layer 161, a second peripheral conductive layer 163 on the first peripheral conductive layer 162, a third peripheral conductive layer 164 on the second peripheral conductive layer 163, a peripheral capping layer 165 on the third peripheral conductive layer 164, and a peripheral spacer 166. The first, second, and third peripheral conductive layers 162, 163, and 164 may include a conductive material. For example, the first and second peripheral conductive layers 162 and 163 may include polysilicon, and the third peripheral conductive layer 164 may include metal. The peripheral dielectric layer 161, the peripheral capping layer 165, and the peripheral spacer 166 may include a dielectric material.

A liner 170 may be provided on the dummy line structure 140, the gate structure 150, the dielectric structure 10, and the peripheral gate structure 160. A first filling layer 181 may be provided on the liner 170. The first filling layer 181 may be provided between the dummy line structure 140 and the peripheral gate structure 160. A second filling layer 182 may be provided on the liner 170 and the first filling layer 181. The second filling layer 182 may overlap in the third direction D3 with the dummy line structure 140, the first filling layer 181, and the peripheral gate structure 160. The liner 170, the first filling layer 181, and the second filling layer 182 may include a dielectric material. In some embodiments, each of the liner 170, the first filling layer 181, and the second filling layer 182 may include a plurality of dielectric layers.

Conductive structures 191 may be provided on the second filling layer 182. The conductive structures 191 may include a conductive material. At least one of the conductive structures 191 may include a gate contact 192 electrically connected to the gate electrode GE of the gate structure 150. The gate contact 192 may penetrate or extend into the gate capping layer 154 of the gate structure 150. The dummy line DL of the dummy line structure 140 may be disposed between the gate contact 192 and the bit line BL of the bit-line structure 130.

Second separation structures 260 may be provided. The second separation structure 260 may separate the conductive structures 191 from each other. The second separation structure 260 may include a dielectric material. In some embodiments, the first separation structure 250 and the second separation structure 260 may be connected to have a single unitary structure without any boundary.

Referring to FIG. 1G, the dummy line DL may at least partially surround the dummy dielectric layers 270 and the inner dummy spacers 146. The inner dummy spacer 146 may at least partially surround the dummy dielectric layer 270. The dummy line DL may include first dummy line parts DL1, second dummy line parts DL2, and connection parts DL3. Each of the first dummy line part DL1, the second dummy line part DL2, and the connection part DL3 may include a portion of the first dummy conductive layer 141, a portion of the second dummy conductive layer 142, and a portion of the third dummy conductive layer 143. It is illustrated for convenience of description that the dummy line DL is divided into the first dummy line parts DL1, the second dummy lines DL2, and the connection parts DL3, but no physical boundaries may be present between the first dummy line parts DL1, the second dummy lines DL2, and the connection parts DL3.

The first dummy line part DL1 may be provided between the dummy dielectric layer 270 and the bit line BL. The first dummy line part DL1 may be provided between the inner dummy spacer 146 and the bit line BL. The second dummy line part DL2 may be spaced apart in the first direction D1 from the first dummy line part DL 1. The dummy dielectric layer 270 and the inner dummy spacer 146 may be provided between the first dummy line part DL1 and the second dummy line part DL2.

The connection part DL3 may connect the first dummy line part DL1 and the second dummy line part DL2 to each other. A width in the first direction D1 of the connection part DL3 may be greater than a sum of a width in the first direction D1 of the first dummy line part DL1 and a width in the first direction D1 of the second dummy line part DL2. Two first dummy line parts DL1 and two second dummy line parts DL2 may be connected to one connection part DL3. The first dummy line parts DL1 and the connection parts DL3 may be alternately arranged along the second direction D2. The second dummy line parts DL2 and the connection parts DL3 may be alternately arranged along the second direction D2. The dummy dielectric layers 270 and the connection parts DL3 may be alternately arranged along the second direction D2. The inner dummy spacers 146 and the connection parts DL3 may be alternately arranged along the second direction D2.

The first dummy line part DL1, the dummy dielectric layer 270, the inner dummy spacer 146, and the second dummy line part DL2 may be provided between two connection parts DL3 that are adjacent to each other in the second direction D2. The width in the first direction D1 of the first dummy line part DL1 may be the same as a width in the first direction D1 of the bit line BL. The width in the first direction D1 of the first dummy line part DL1 may be less than the width in the first direction D1 of the second dummy line part DL2.

The dielectric fences (see 240 of FIG. 1C or 1D) may be provided between the first dummy line part DL1 and the bit line BL. A width in the second direction D2 of the dielectric fence 240 may be less than a width in the second direction D2 of the dummy dielectric layer 270.

The dummy line DL may include a first outer sidewall, a second outer sidewall opposite to the first outer sidewall, and inner sidewalls. The first outer sidewall of the dummy line DL may be adjacent to the bit line BL. The inner sidewalls of the dummy line DL may be disposed between the first and second outer sidewalls of the dummy line DL.

The first outer dummy spacer 145 may be in contact with the first outer sidewall of the dummy line DL. The second outer dummy spacer 147 may be in contact with the second outer sidewall of the dummy line DL. The inner dummy spacer 146 may be in contact with the inner sidewalls of the dummy line DL. The first dummy line part DL1 may be disposed between the first outer dummy spacer 145 and the inner dummy spacer 146. The second dummy line part DL2 may be disposed between the second outer dummy spacer 147 and the inner dummy spacer 146. The connection part DL3 may be disposed between the first and second outer dummy spacers 145 and 147.

The first outer sidewall of the dummy line DL may include outer sidewalls DL1_S1 of the first dummy line parts DL1 and first outer sidewalls DL3_S3 of the connection parts DL3. The outer sidewalls DL1_S1 of the first dummy line parts DL1 may be coplanar with the first outer sidewalls DL3_S3 of the connection parts DL3. The outer sidewalls DL1_S1 of the first dummy line parts DL1 and the first outer sidewalls DL3_S3 of the connection parts DL3 may be disposed on a straight line that extends in the second direction D2.

The second outer sidewall of the dummy line DL may include outer sidewalls DL2_S2 of the second dummy line parts DL2 and second outer sidewalls DL3_S4 of the connection parts DL3. The outer sidewalls DL2_S2 of the second dummy line parts DL2 may be coplanar with the second outer sidewalls DL3_S4 of the connection parts DL3. The outer sidewalls DL2_S2 of the second dummy line parts DL2 and the second outer sidewalls DL3_S4 of the connection parts DL3 may be disposed on a straight line that extends in the second direction D2.

The inner sidewalls of the dummy line DL may include an inner sidewall DL1_S2 of the first dummy line part DL1, an inner sidewall DL2_S12 of the second dummy line part DL2, and a first inner sidewall DL3_S1 and a second inner sidewall DL3_S2 of the connection part DL3. The inner sidewall DL1_S2 of the first dummy line part DL1 and the inner sidewall DL2_S1 of the second dummy line part DL2 may be connected to the first inner sidewall DL3_S1 and the second inner sidewall DL3_S2 of the connection part DL3. The inner sidewall DL1_S2 of the first dummy line part DL1 and the inner sidewall DL2_S1 of the second dummy line part DL2 may be parallel to the second direction D2. The first inner sidewall DL3_S1 and the second inner sidewall DL3_S2 of the connection part DL3 may be parallel to the first direction D 1. A length in the second direction D2 of each of the inner sidewall DL1_S2 of the first dummy line part DL1 and the inner sidewall DL2_S1 of the second dummy line part DL2 may be greater than a length in the first direction D1 of each of the first inner sidewall DL3_S1 and the second inner sidewall DL3_S2 of the connection part DL3.

The inner dummy spacer 146 may include first parts that extend in the first direction D1 and second parts that extend in the second direction D2. The first part of the inner dummy spacer 146 may be in contact with one of the first inner sidewall DL3_S1 and the second inner sidewall DL3_S2 of the connection part DL3. The second part of the inner dummy spacer 146 may be in contact with one of the inner sidewall DL1_S2 of the first dummy line part DL1 and the inner sidewall DL2_S1 of the second dummy line part DL2. The first parts of the inner dummy spacer 146 may be spaced apart from each other in the second direction D2. The second parts of the inner dummy spacer 146 may be spaced apart from each other in the first direction D1. The first parts of the inner dummy spacer 146 may connect to each other the second parts of the inner dummy spacer 146. A length in the first direction D1 of the first part of the inner dummy spacer 146 may be less than a length in the second direction D2 of the second part of the inner dummy spacer 146.

As the semiconductor device according to some embodiments includes the dummy dielectric layer 270 and the inner dummy spacer 146 at least partially surrounded by the dummy line DL, it may be possible to improve uniformity of the cell region CR and electrical properties of the semiconductor device.

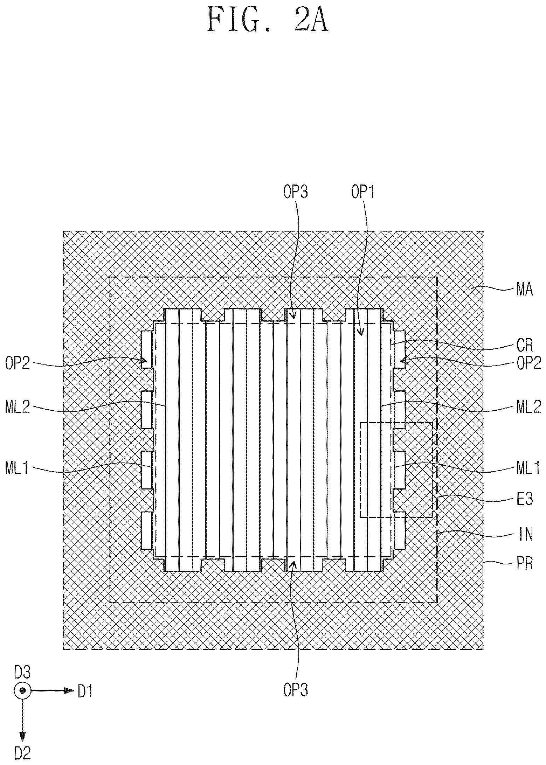

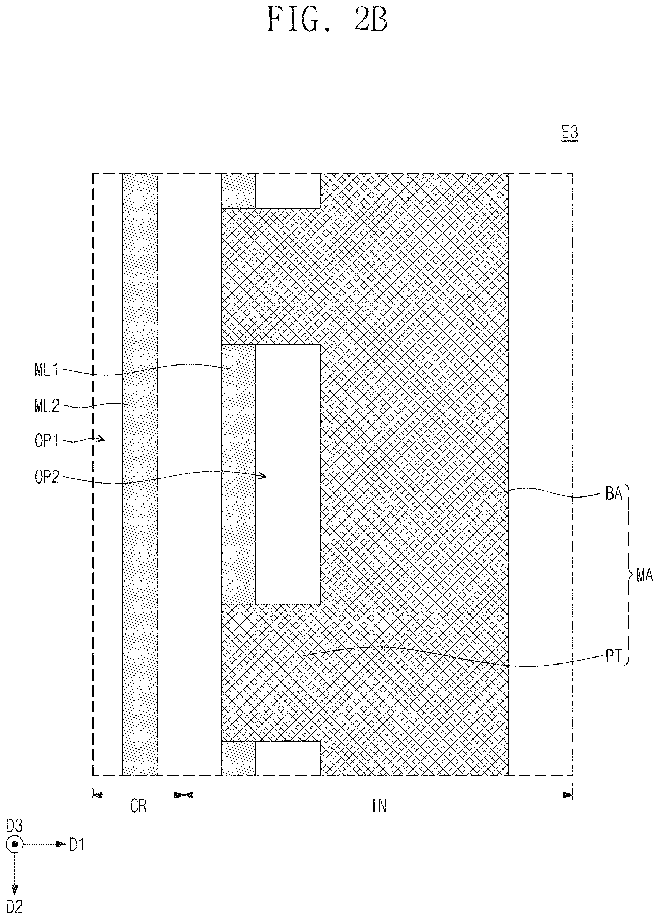

FIGS. 2A, 2B, 2C, 2D, 2E, 3A, 3B, 3C, 3D, 4A, 4B, 4C, 5a, 5B, 5C illustrate diagrams showing a method of fabricating a semiconductor device according to FIGS. 1A to 1G. FIG. 2B illustrates an enlarged view showing section E3 of FIG. 2A.

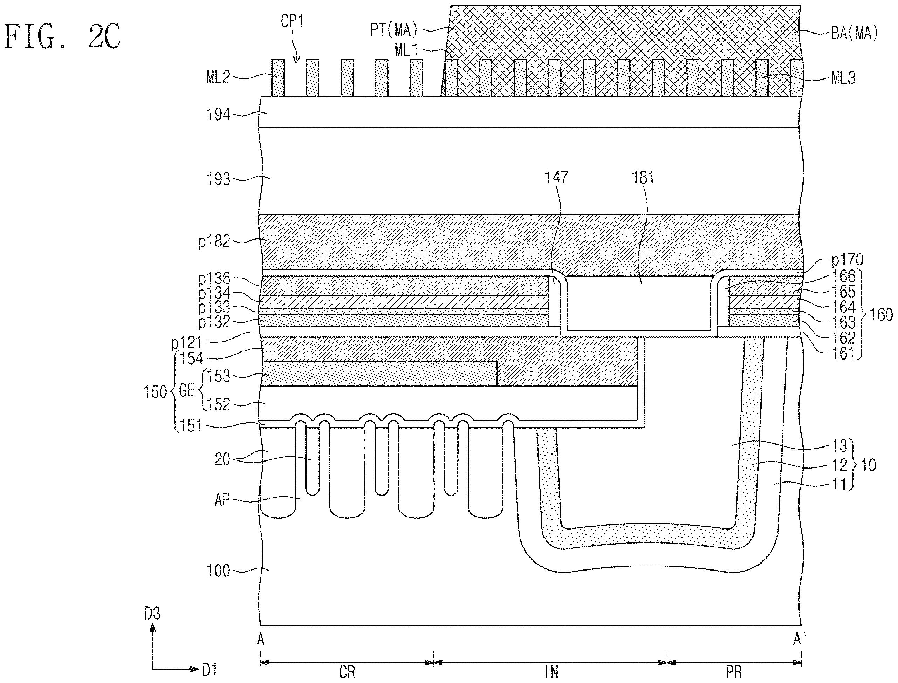

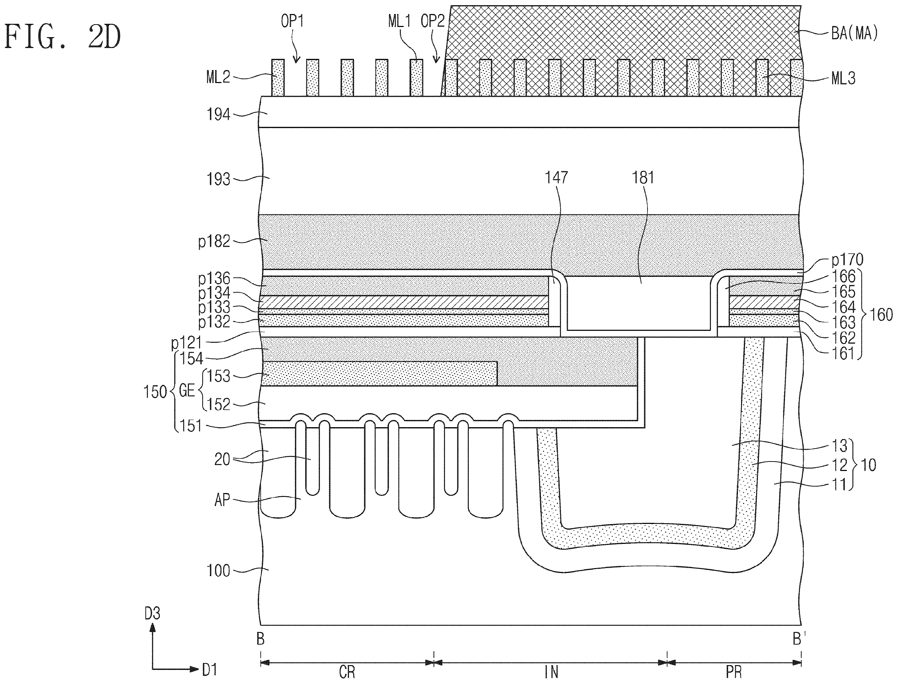

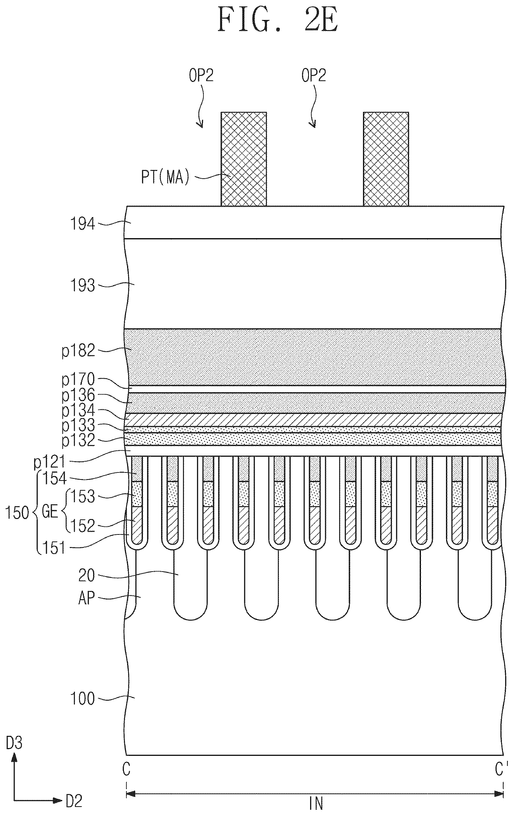

Referring to FIGS. 2A, 2B, 2C, 2D, and 2E, a substrate 100 may be provided which includes a cell region CR, an interface region IN, and a peripheral region PR. A device isolation layer 20 and a dielectric structure 10 may be formed on the substrate 100. Active patterns AP of the substrate 100 may be formed.

Gate structures 150 may be formed on the active patterns AP, the dielectric structure 10, and the device isolation layer 20. A preliminary dielectric pattern p121 may be formed on the gate structures 150. The preliminary dielectric pattern p121 may include a dielectric material.

A first preliminary conductive layer p132 may be formed on the preliminary dielectric pattern p121. Bit-line contacts (see 131 of FIG. 1F) may be formed to penetrate or extend into the first preliminary conductive layer p132 and the preliminary dielectric pattern p121. A second preliminary conductive layer p133 may be formed on the first preliminary conductive layer p132. A third preliminary conductive layer p134 may be formed on the second preliminary conductive layer p133. A preliminary capping layer p136 may be formed on the third preliminary conductive layer p134. The first and second preliminary conductive layers p132 and p133 may include a conductive material. For example, the first and second preliminary conductive layers p132 and p133 may include polysilicon. The third preliminary conductive layer p134 may include a conductive material. For example, the third preliminary conductive layer p134 may include metal. The preliminary capping layer p136 may include a dielectric material.

A second outer dummy spacer 147 may be formed on sidewalls of the first, second, and third preliminary conductive layers p132, p133, and p134 and the preliminary capping layer p136. Peripheral gate structures 160 may be formed to overlap in a third direction D3 with the peripheral region PR. A preliminary liner p170 may be formed on the peripheral gate structure 160, the preliminary capping layer p136, and the second outer dummy spacer 147. The preliminary liner p170 may include a dielectric material. A first filling layer 181 may be formed between the peripheral gate structure 160 and the second outer dummy spacer 147. A preliminary filling layer p182 may be formed on the preliminary liner p170 and the first filling layer 181. The preliminary filling layer p182 may include a dielectric material.

A first material layer 193 may be formed on the preliminary filling layer p182. A second material layer 194 may be formed on the first material layer 193. The first and second material layers 193 and 194 may include a dielectric material.

First mask lines ML1, second mask lines ML2, and third mask lines ML3 may be formed on the second material layer 194. The first, second, and third mask lines ML1, ML2, and ML3 may extend in a second direction D2. The first, second, and third mask lines ML1, ML2, and ML3 may be arranged spaced apart from each other in a first direction D1. The first, second, and third mask lines MI,1, ML2, and ML3 may include a dielectric material. For example, the first, second, and third mask lines ML1, ML2, and ML3 may include oxide.

A mask layer MA may be formed on the second material layer 194. The mask layer MA may include a photoresist material. The mask layer MA may include a first opening OP1, second openings OP2, and third openings OP3. The formation of the mask layer MA may include forming a preliminary mask layer on the second material layer 194 and performing a photolithography process to form a first opening OP1, second openings OP2, and third openings OP3 on the preliminary mask layer.

The first opening OP1 may overlap in the third direction D3 with the cell region CR. The second openings OP2 and the third openings OP3 may overlap in the third direction D3 with the interface region IN. The second openings OP2 and the third openings OP3 may be connected to the first opening OP1. The second openings OP2 may be connected to one of a first side and a second side of the first opening OP1. The first side and the second side of the first opening OP1 may be spaced apart from each other in the first direction D1. The third openings OP3 may be connected to one of a third side and a fourth side of the first opening OP1. The third side and the fourth side of the first opening OP1 may be spaced apart from each other in the second direction D2.

The mask layer MA may include a base part BA and protrusion parts PT. The base part BA may overlap in the third direction D3 with the peripheral region PR and the interface region IN. When viewed in plan as shown in FIG. 2A, the base part BA may at least partially surround the interface region IN and the cell region CR. The protrusion parts PT may protrude or extend from the base part BA toward the cell region CR. The protrusion parts PT may overlap in the third direction D3 with the interface region IN.

The protrusion parts PT and the second openings OP2 connected to the first side of the first opening OP1 may be alternately arranged along the second direction D2. The protrusion parts PT and the third openings OP3 connected to the third side of the first opening OP1 may be alternately arranged along the first direction D1.

The second mask lines ML2 may be disposed between the first mask lines ML1. The first and second mask lines ML1 and ML2 may be disposed between the third mask lines ML3. The first mask line ML1 may be disposed between the second and third mask lines ML2 and ML3.

The second mask line ML2 may be exposed by the first opening OP1 or by the first opening OP1 and two third openings OP3. The first mask line ML1 may include first parts exposed by the second openings OP2 and second parts covered or overlapped with the protrusion parts PT. The first parts and the second parts of the first mask line ML1 may be alternately arranged along the second direction D2. The third mask line ML3 may be covered or overlapped with the base part BA of the mask layer MA.

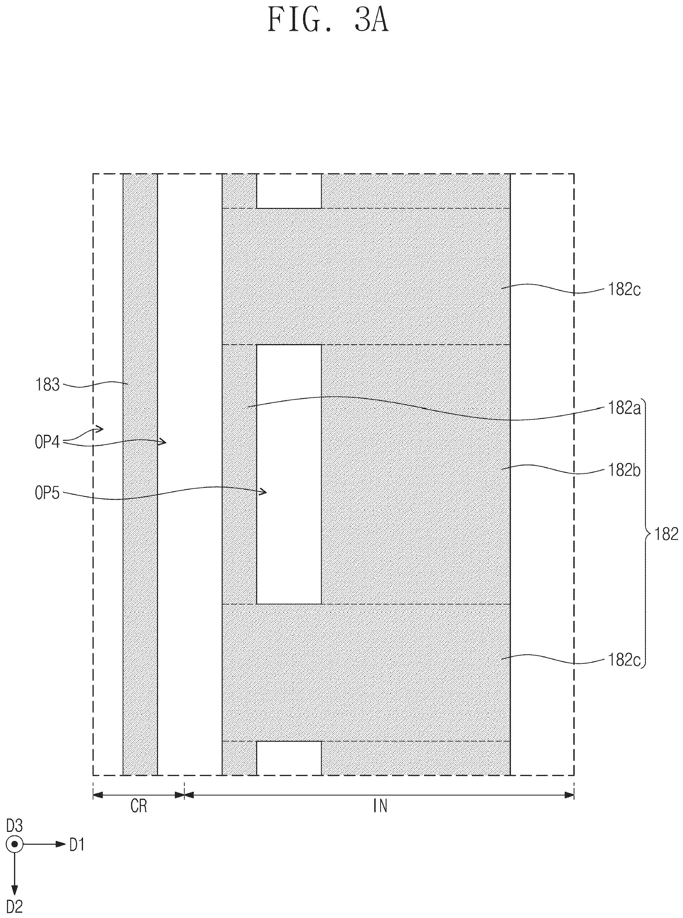

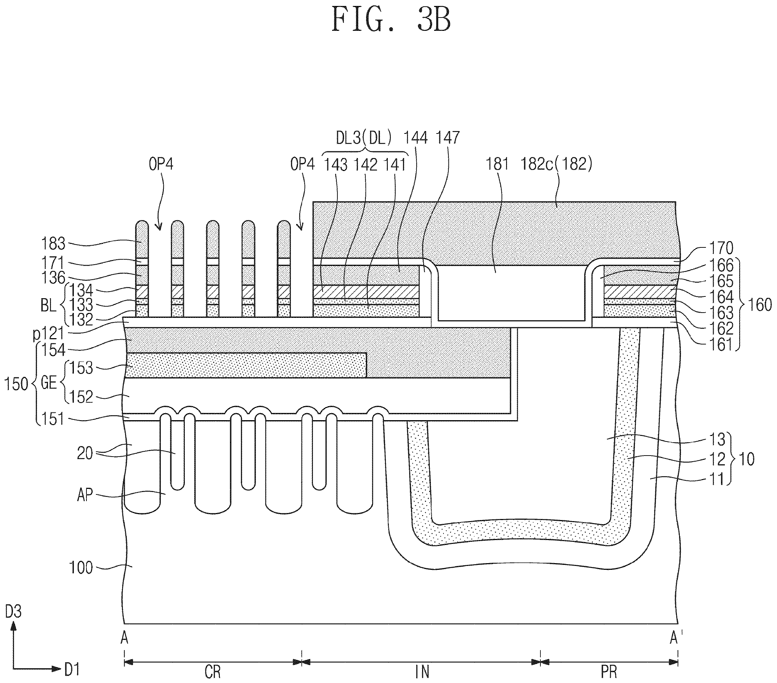

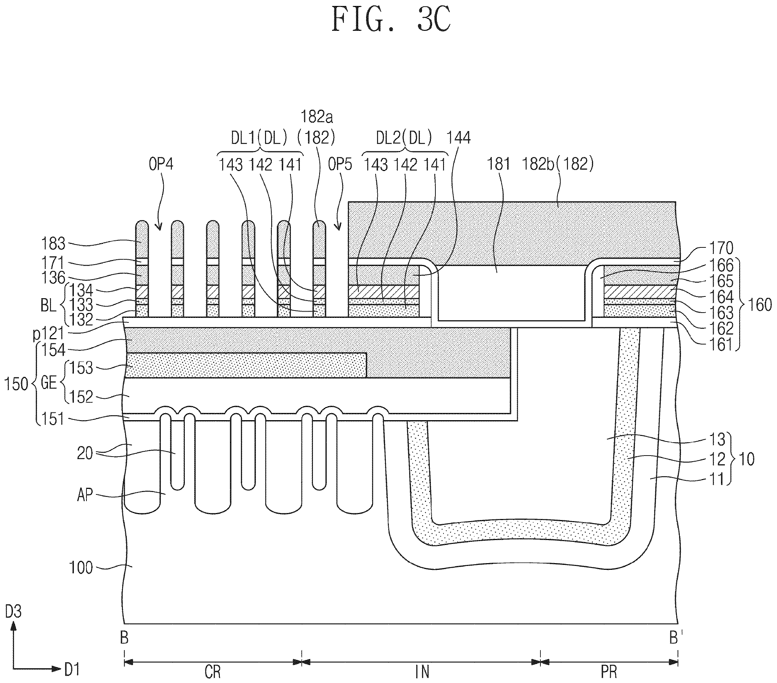

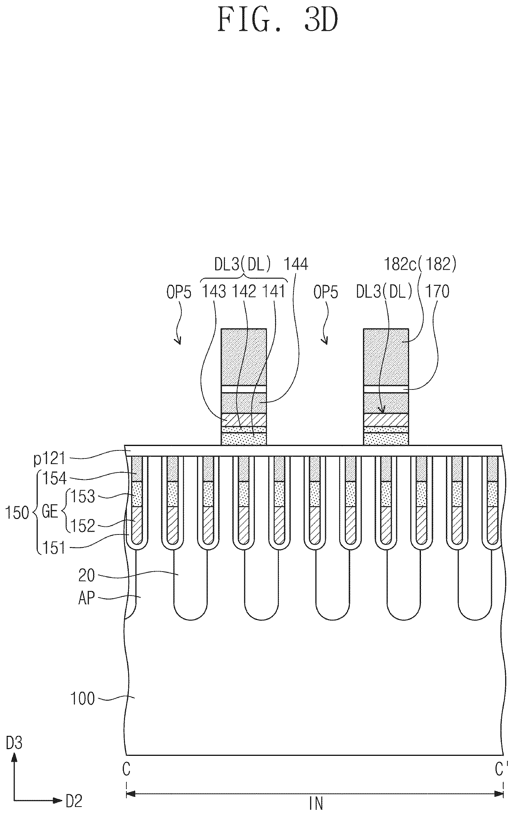

Referring to FIGS. 3A, 3B, 3C, and 3D, an etching process may be performed which uses the mask layer MA and the first, second, and third mask lines ML1, ML2, and ML3. The etching process may remove the mask layer MA, the first, second, and third mask lines ML1, ML2, and ML3, the first material layer 193, and the second material layer 194.

The etching process may etch the preliminary filling layer p182, the preliminary liner p170, the preliminary capping layer p136, and the first, second, and third preliminary conductive layers p132, p133, and p134. The preliminary filling layer p182 may be etched to separate the preliminary filling layer p182 into a second filling layer 182 and third bit-line capping layers 183. The preliminary liner p170 may be etched to separate the preliminary liner p170 into second bit-line capping layers 171 and a liner 170. The preliminary capping layer p136 may be etched to separate the preliminary capping layer p136 into first bit-line capping layers 136 and a dummy line capping layer 144. The third preliminary conductive layer p134 may be etched to separate the third preliminary conductive layer p134 into third conductive layers 134 and a third dummy conductive layer 143. The second preliminary conductive layer p133 may be etched to separate the second preliminary conductive layer p133 into second conductive layers 133 and a second dummy conductive layer 142. The first preliminary conductive layer p132 may be etched to separate the first preliminary conductive layer p132 into first conductive layers 132 and a first dummy conductive layer 141.

The second filling layer 182 may include first filling parts 182a, second filling parts 182b, and third filling parts 182c. The third filling part 182c may connect the first filling part 182a and the second filling part 182b to each other. Two first filling parts 182a and two second filling parts 182b may be connected to one third filling part 182c. The first filling parts 182a and third filling parts 182c may be alternately arranged along the second direction D2. The second filling parts 182b and the third filling parts 182c may be alternately arranged along the second direction D2.

An uppermost portion of the first filling part 182a may be located at a lower level than that of an uppermost portion of the second filling part 182b and that of an uppermost portion of the third filling part 182c.

Fourth openings OP4 and fifth openings OP5 may be defined. The fourth opening OP4 may be defined between the third bit-line capping layers 183 that are adjacent to each other or between the third bit-line capping layer 183 and the second filling layer 182 that are adj acent to each other. The fifth opening OP5 may be at least partially surrounded by the second filling layer 182. The fifth opening OP5 may be disposed between the first and second filling parts 182a and 182b. The fifth opening OP5 may be disposed between the third filling parts 182c. The preliminary dielectric pattern p121 may be exposed by the fourth and fifth openings OP4 and OP5.

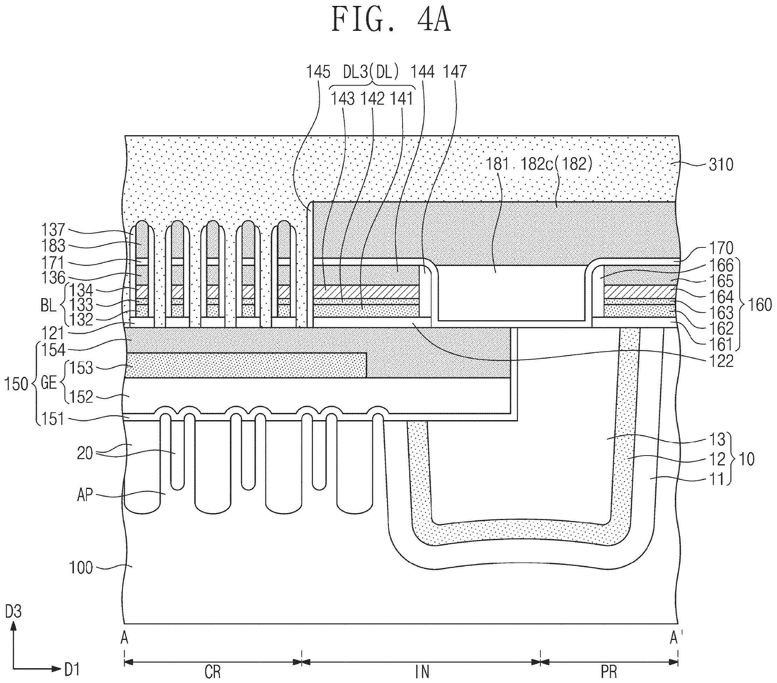

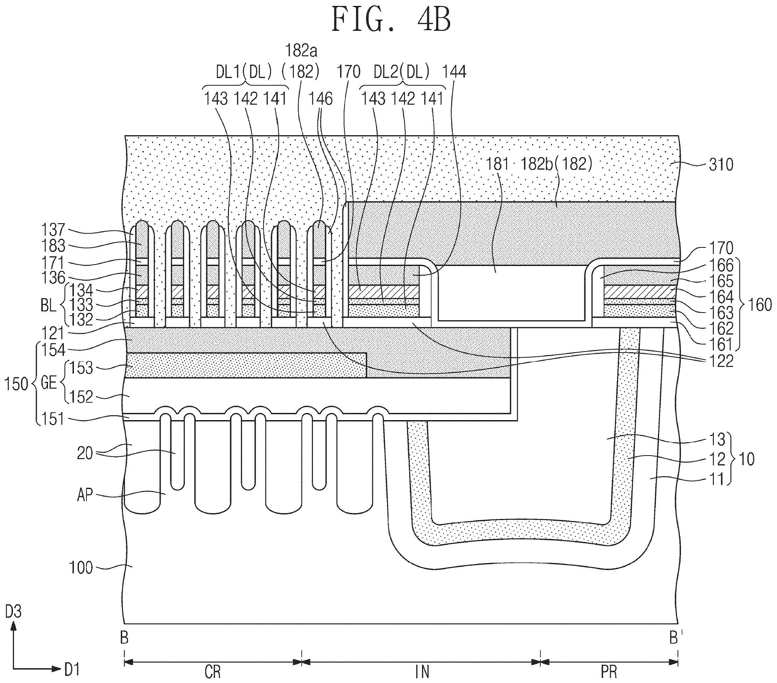

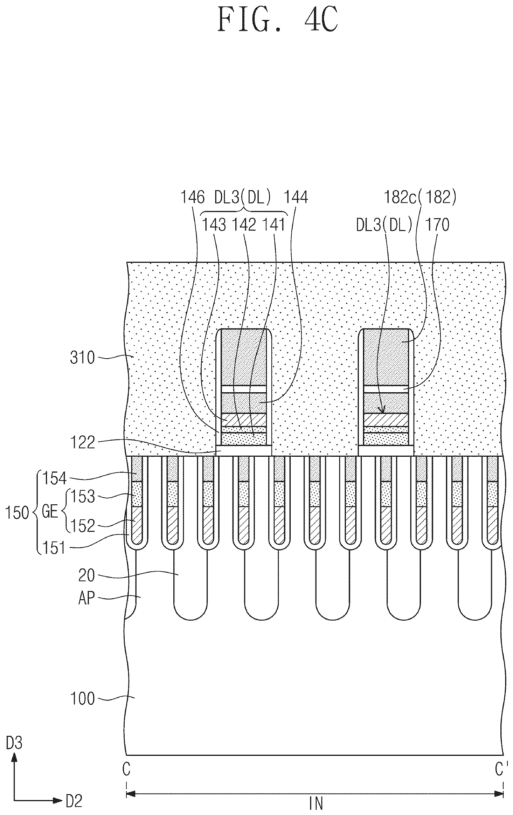

Referring to FIGS. 4A, 4B, and 4C, there may be formed bit-line spacers 137, a first outer dummy spacer 145, and inner dummy spacers 146. The inner dummy spacer 146 may be formed in the fifth opening OP5.

The preliminary dielectric pattern p121 may be etched. The preliminary dielectric pattern p 121 may be etched to separate into dielectric patterns 121 and a dummy dielectric pattern 122.

A sacrificial layer 310 may be formed. The sacrificial layer 310 may be formed on the second filling layer 182, the third bit-line capping layers 183, the bit-line spacers 137, the first outer dummy spacer 145, and the inner dummy spacers 146. The sacrificial layer 310 may fill the fourth openings OP4 and the fifth openings OP5. The sacrificial layer 310 may include, for example, polysilicon.

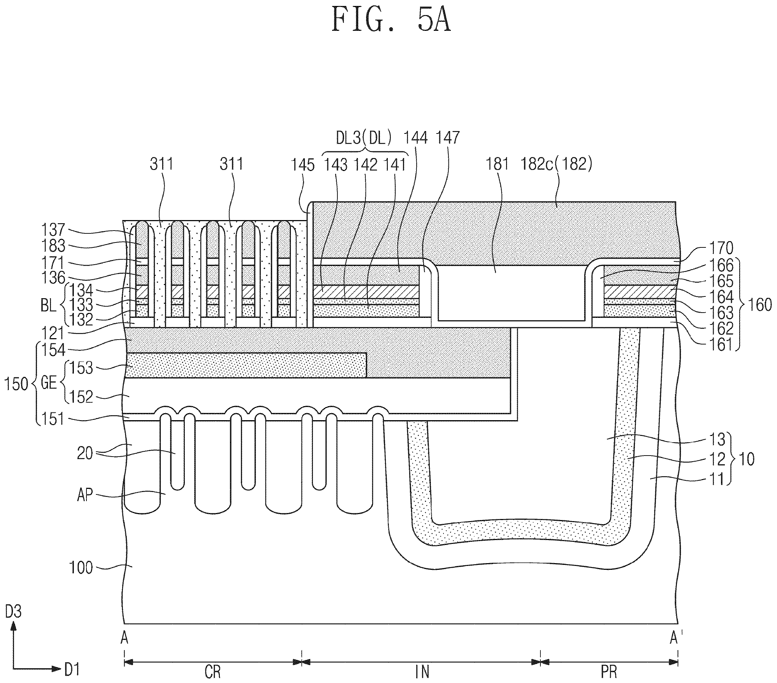

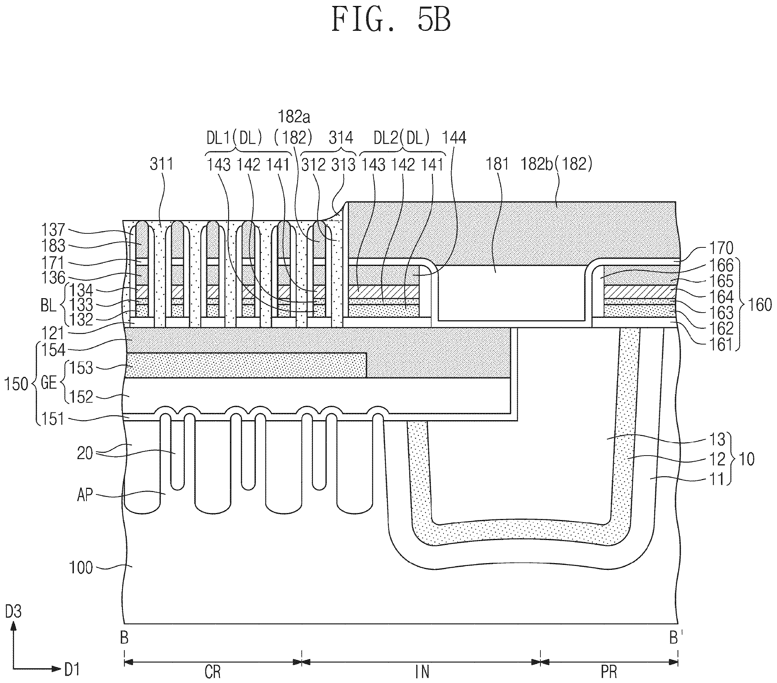

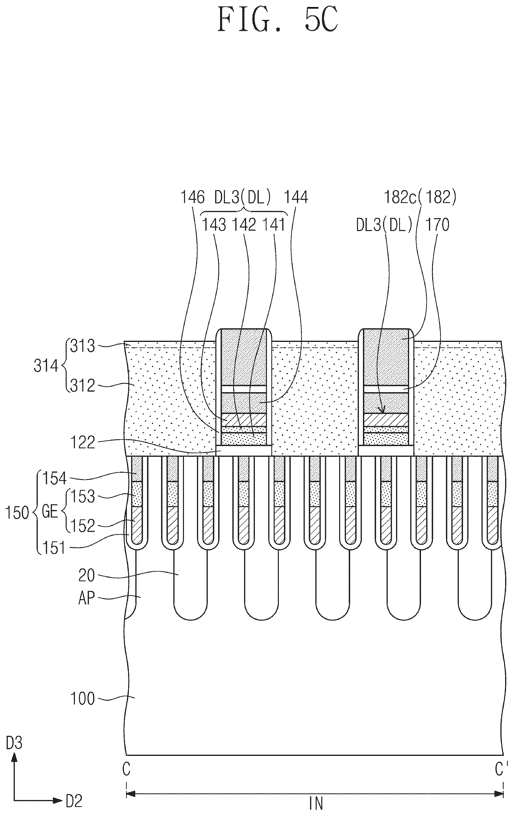

Referring to FIGS. 5A, 5B, and 5C, an upper portion of the sacrificial layer 310 may be removed. For example, the upper portion of the sacrificial layer 310 may be removed by a chemical mechanical polishing (CMP) process. The upper portion of the sacrificial layer 310 may be removed to divide the sacrificial layer 310 into first sacrificial patterns 311 and second sacrificial patterns 314. The first sacrificial pattern 311 may be disposed in the fourth opening OP4. The first sacrificial pattern 311 may overlap in the third direction D3 with the cell region CR. The second sacrificial pattern 314 may be disposed on the fifth opening OP5. The second sacrificial pattern 314 may overlap in the third direction D3 with the interface region IN. The second sacrificial pattern 314 may be at least partially surrounded by the dummy line DL, the dummy line capping layer 144, the inner dummy spacer 146, and the second filling layer 182.

The second sacrificial pattern 314 may include an upper part 313 and a lower part 312. The upper part 313 of the second sacrificial pattern 314 may be located at a higher level than that of the first sacrificial pattern 311. An uppermost portion of the second sacrificial pattern 314 may be located at a higher level than that of an uppermost portion of the first sacrificial pattern 311.

Referring to FIGS. 1A, 1B, 1C, 1D, 1E, and 1F, the first and second sacrificial patterns 311 and 314 may be removed. There may be formed dielectric fences 240, a dummy dielectric layer 270, a first separation structure 250, node contacts NC, landing pads LP, data storage patterns DSP, conductive structures 191, and second separation structures 260.

In a method of fabricating a semiconductor device according to some embodiments, the mask layer MA including the second and third openings OP2 and OP3 may be used to perform a cell open process to form the fifth openings OP5 that overlap the interface region IN. As the fifth openings OP5 are additionally formed, in the process to remove the upper portion of the sacrificial layer 310, an effect due to shadowing may be relatively largely given to the second sacrificial pattern 314 and relatively less given to the first sacrificial pattern 311. Therefore, as the first sacrificial patterns 311 have a relatively uniform height, it may be possible to improve stability of subsequent processes on the cell region CR and also to enhance uniformity on the cell region CR.

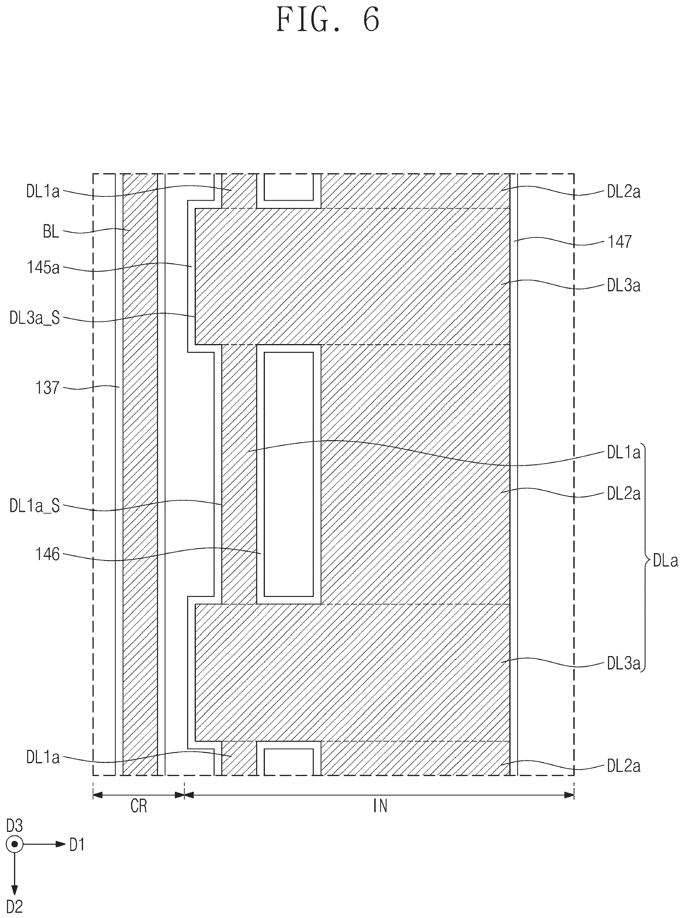

FIG. 6 illustrates an enlarged plan view showing a semiconductor device according to some embodiments. Except for the following description, a semiconductor device according to FIG. 6 may be similar to the semiconductor device according to FIGS. 1A to 1G.

Referring to FIG. 6, a dummy line DLa may include first dummy line parts DL1a, second dummy line parts DL2a, and connection parts DL3a. A distance in the first direction D1 between the connection parts DL3a and the bit line BL may be less than a distance in the first direction D1 between the first dummy line parts DL1a and the bit line BL.

A distance in the first direction D1 between the bit line BL and an outer sidewall DL3a_S of the connection part DL3a may be less than a distance in the first direction D1 between the bit line BL and an outer sidewall DL1a_S of the first dummy line part DL1a.

A first outer dummy spacer 145a may include first parts that extend in the second direction D2 and second parts that extend in the first direction D1. The first part of the first outer dummy spacer 145a may be in contact with the outer sidewall DL3a_S of the connection part DL3a and the outer sidewall DL1a_S of the first dummy line part DL1a. The second part of the first outer dummy spacer 145a may be connected to the first parts of the first outer dummy spacer 145a.

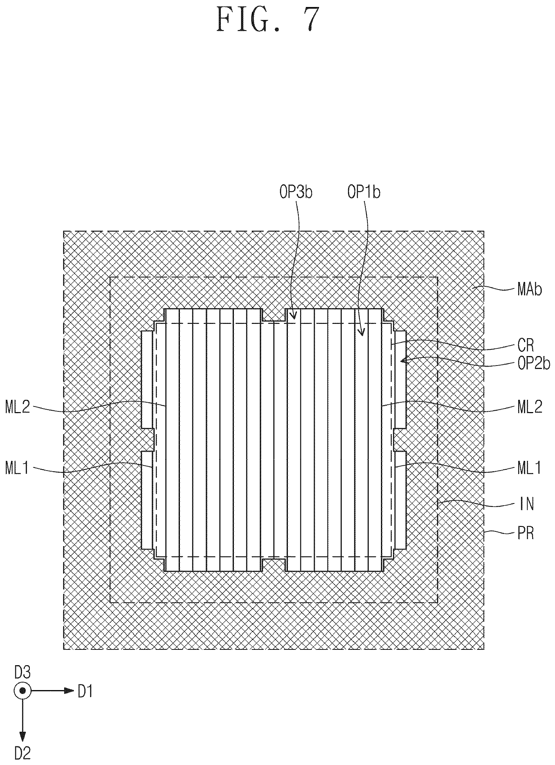

FIG. 7 illustrates a plan view showing a method of fabricating a semiconductor device according to some embodiments. Except for the following description, a method of fabricating a semiconductor device according to FIG. 7 may be similar to the method of fabricating a semiconductor device according to FIGS. 2A to 5C.

Referring to FIG. 7, a mask layer MAb may include a first opening OP1b that overlaps in the third direction D3 with the cell region CR, second openings OP2b connected to one of a first side and a second side of the first opening OP1b, and third openings OP3b connected to one of a third side and a fourth side of the first opening OP1b.

Two second openings OP2b may be connected to each of the first side and the second side of the first opening OP1b. Two third openings OP3b may be connected to each of the third side and the fourth side of the first opening OP1b. The first, second, and third openings OP1b, OP2b, and OP3b may have their sidewalls parallel to the first direction D1 or the second direction D2.

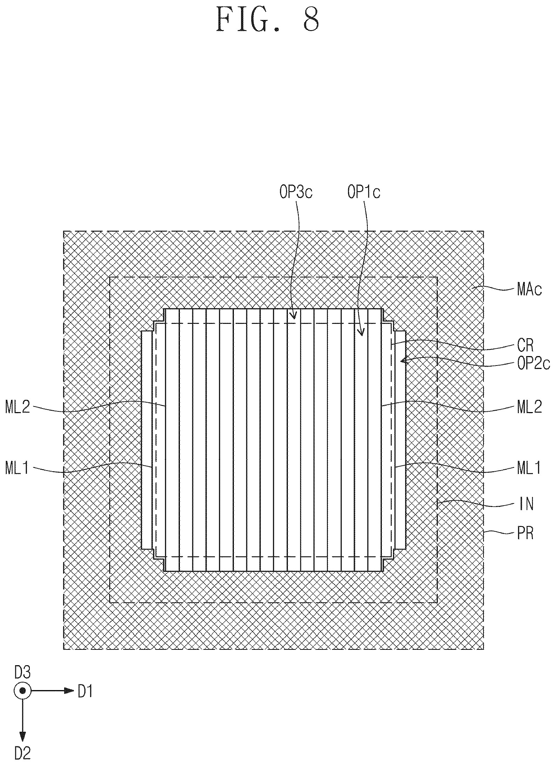

FIG. 8 illustrates a plan view showing a method of fabricating a semiconductor device according to some embodiments. Except for the following description, a method of fabricating a semiconductor device according to FIG. 8 may be similar to the method of fabricating a semiconductor device according to FIGS. 2A to 5C.

Referring to FIG. 8, a mask layer Mac may include a first opening OP1c that overlaps in the third direction D3 with the cell region CR, second openings OP2c connected to one of a first side and a second side of the first opening OP1c, and third openings OP3c connected to one of a third side and a fourth side of the first opening OP1c.

One second opening OP2c may be connected to each of the first side and the second side of the first opening OP1c. One third opening OP3c may be connected to each of the third side and the fourth side of the first opening OP1c.

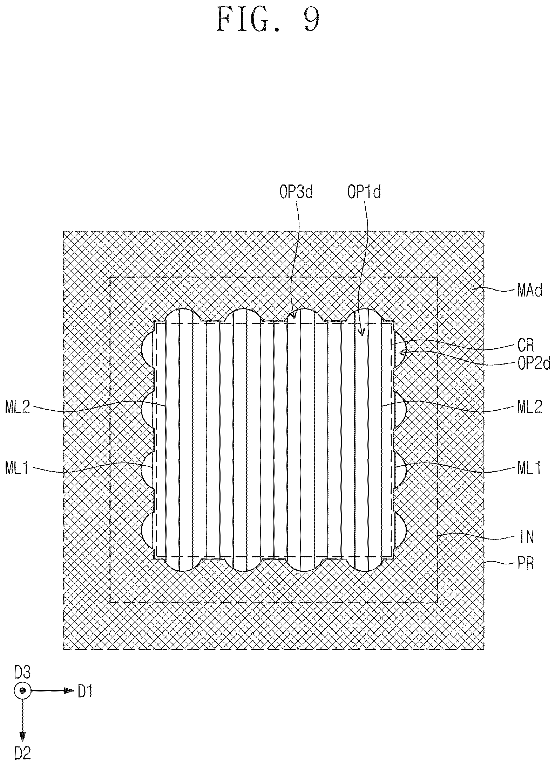

FIG. 9 illustrates a plan view showing a method of fabricating a semiconductor device according to some embodiments. Except for the following description, a method of fabricating a semiconductor device according to FIG. 9 may be similar to the method of fabricating a semiconductor device according to FIGS. 2A to 5C.

Referring to FIG. 9, a mask layer MAd may include a first opening OP1d that overlaps in the third direction D3 with the cell region CR, second openings OP2d connected to one of a first side and a second side of the first opening OP1d, and third openings OP3d connected to one of a third side and a fourth side of the first opening OP1d.

Four second openings OP2d may be connected to each of the first side and the second side of the first opening OP1d. Four third openings OP3d may be connected to each of the third side and the fourth side of the first opening OP1d.

The second opening OP2d may have a curved sidewall. The mask layer MAd may have a curved sidewall that defines the second opening OP2d. The third opening OP3d may have a curved sidewall. The mask layer MAd may have a curved sidewall that defines the third opening OP3d. The second opening OP2 and the third opening OP3d may have their arc-shaped sidewalls.

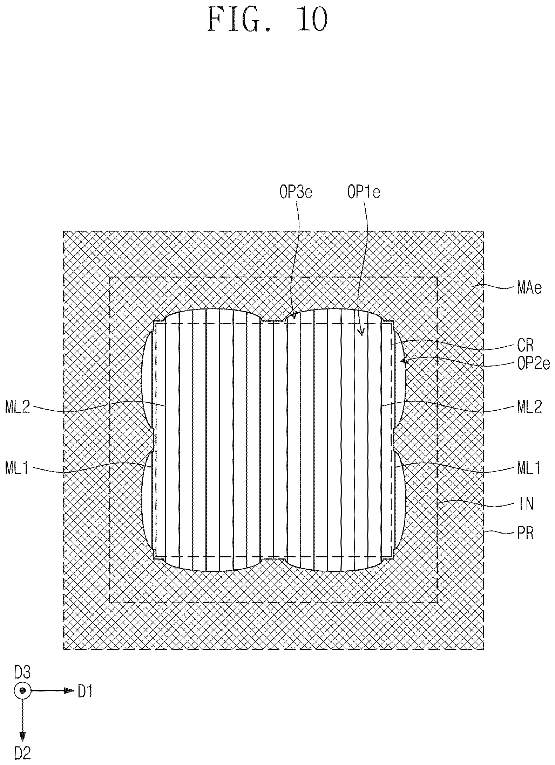

FIG. 10 illustrates a plan view showing a method of fabricating a semiconductor device according to some embodiments. Except for the following description, a method of fabricating a semiconductor device according to FIG. 10 may be similar to the method of fabricating a semiconductor device according to FIGS. 2A to 5C.

Referring to FIG. 10, a mask layer MAe may include a first opening OP1e that overlaps in the third direction D3 with the cell region CR, second openings OP2e connected to one of a first side and a second side of the first opening OP1e, and third openings OP3e connected to one of a third side and a fourth side of the first opening OP1e.

Two second openings OP2e may be connected to each of the first side and the second side of the first opening OP1e. Two third openings OP3e may be connected to each of the third side and the fourth side of the first opening OP1e.

The second opening OP2e may have a curved sidewall. The third opening OP3e may have a curved sidewall.

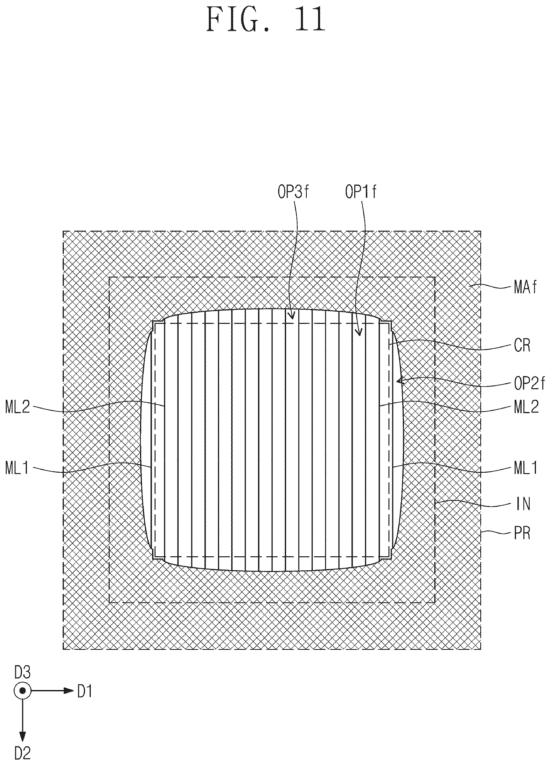

FIG. 11 illustrates a plan view showing a method of fabricating a semiconductor device according to some embodiments. Except for the following description, a method of fabricating a semiconductor device according to FIG. 11 may be similar to the method of fabricating a semiconductor device according to FIGS. 2A to 5C.

Referring to FIG. 11, a mask layer MAf may include a first opening OP1f that overlaps in the third direction D3 with the cell region CR, second openings OP2f connected to one of a first side and a second side of the first opening OP1f, and third openings OP3f connected to one of a third side and a fourth side of the first opening OP1f.

One second opening OP2f may be connected to each of the first side and the second side of the first opening OP1f. One third opening OP3f may be connected to each of the third side and the fourth side of the first opening OP1f.

The second opening OP2f may have a curved sidewall. The third opening OP3f may have a curved sidewall.

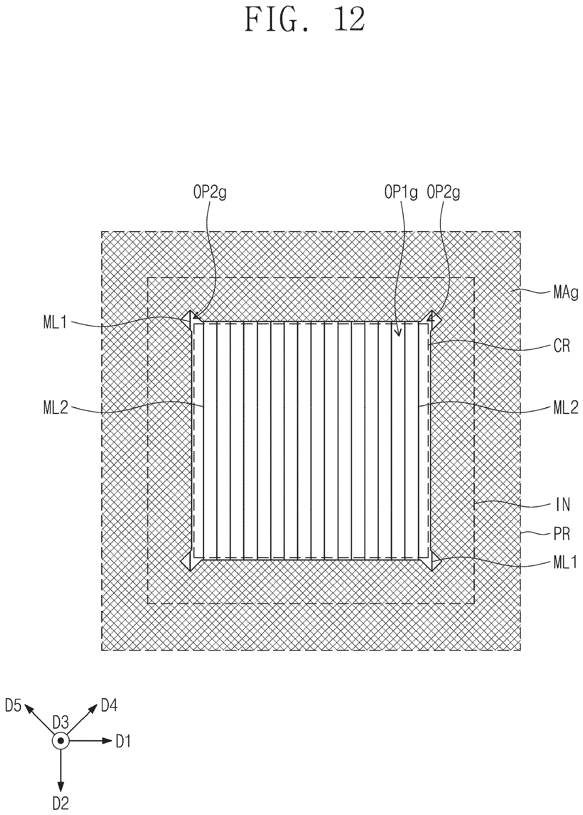

FIG. 12 illustrates a plan view showing a method of fabricating a semiconductor device according to some embodiments. Except for the following description, a method of fabricating a semiconductor device according to FIG. 12 may be similar to the method of fabricating a semiconductor device according to FIGS. 2A to 5C.

Referring to FIG. 12, a mask layer MAg may include a first opening OP1g that overlaps in the third direction D3 with the cell region CR and second openings OP2g connected to corners of the first opening OP1g.

The first opening OP1g may have sidewalls parallel to the first direction D1 or the second direction D2. The second opening OP2g may have sidewalls parallel to a fourth direction D4 or a fifth direction D5. The fourth direction D4 may intersect the first, second, and third directions D1, D2, and D3. For example, the fourth direction D4 may be a horizontal direction that intersects the first and second directions D1 and D2 and is perpendicular to the third direction D3. The fifth direction D5 may intersect the first, second, third, and fourth directions D1, D2, D3, and D4. For example, the fifth direction D5 may be a horizontal direction that intersects the first and second directions D1 and D2 and is orthogonal to the third and fourth directions D3 and D4.

As the mask layer MAg includes the second openings OP2g connected to corners of the first opening OP1g, an effect due to shadowing may be concentrated on corner sections and thus uniformity in the cell region CR may be improved.

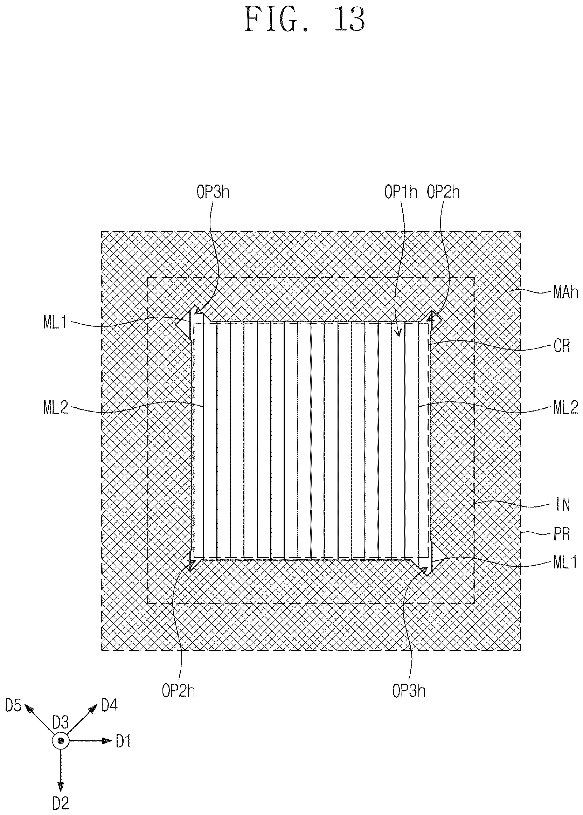

FIG. 13 illustrates a plan view showing a method of fabricating a semiconductor device according to some embodiments. Except for the following description, a method of fabricating a semiconductor device according to FIG. 13 may be similar to the method of fabricating a semiconductor device according to FIGS. 2A to 5C.

Referring to FIG. 13, a mask layer MAh may include a first opening OP1h that overlaps in the third direction D3 with the cell region CR, and may also include second openings OP2h and third openings OP3h connected to corners of the first opening OP1h.

The first opening OP1h may have sidewalls parallel to the first direction D1 or the second direction D2. The second openings OP2h and the third openings OP3h may have their sidewalls parallel to the fourth direction D4 or the fifth direction D5.

The second and third openings OP2h and OP3h that are adjacent to each other may be spaced apart from each other in the first direction D1 or the second direction D2. The second openings OP2h that are adjacent to each other may be spaced apart from each other in the fourth direction D4. The third openings OP3h that are adjacent to each other may be spaced apart from each other in the fifth direction D5.

The second opening OP2h may have a size (e.g., planar area) less than that of the third opening OP3h.

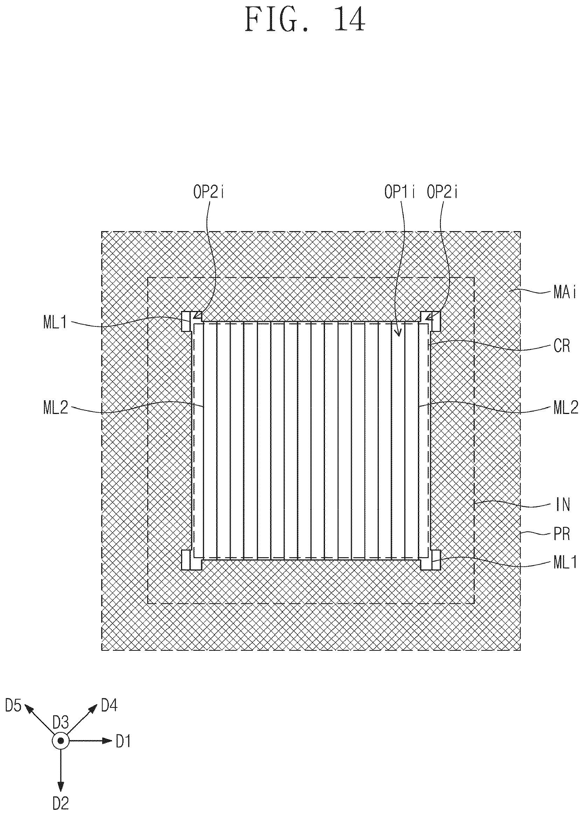

FIG. 14 illustrates a plan view showing a method of fabricating a semiconductor device according to some embodiments. Except for the following description, a method of fabricating a semiconductor device according to FIG. 14 may be similar to the method of fabricating a semiconductor device according to FIGS. 2A to 5C.

Referring to FIG. 14, a mask layer MAi may include a first opening OP1i that overlaps in the third direction D3 with the cell region CR and second openings OP2i connected to corners of the first opening OP1i.

The first opening OP1i and the second openings OP2i may have their sidewalls parallel to the first direction D1 or the second direction D2.

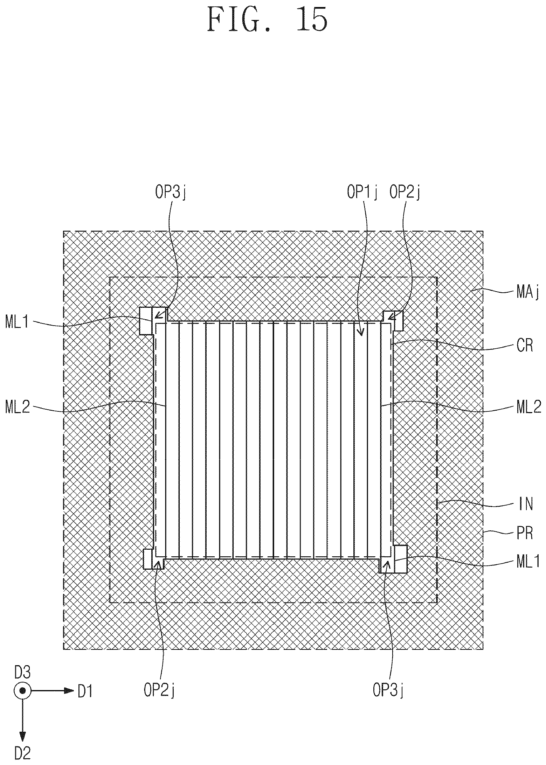

FIG. 15 illustrates a plan view showing a method of fabricating a semiconductor device according to some embodiments. Except for the following description, a method of fabricating a semiconductor device according to FIG. 15 may be similar to the method of fabricating a semiconductor device according to FIGS. 2A to 5C.

Referring to FIG. 15, a mask layer MAj may include a first opening OP1j that overlaps in the third direction D3 with the cell region CR, and may also include second openings OP2j and third openings OP3j connected to corners of the first opening OP1j.

The first, second, and third openings OP1j, OP2j, and OP3j may have their sidewalls parallel to the first direction D1 or the second direction D2.

The second and third openings OP2j and OP3j that are adjacent to each other may be spaced apart from each other in the first direction D1 or the second direction D2. The second openings OP2j that are adjacent to each other may be spaced apart from each other in the fourth direction D4. The third openings OP3j that are adjacent to each other may be spaced apart from each other in the fifth direction D5.

The second opening OP2j may have a size (e.g., planar area) less than that of the third opening OP3j.

In a semiconductor device according to some embodiments of the present disclosure, as a cell open process is performed by using a mask layer including openings that overlap an interface region, it may be possible to improve the stability of subsequent processes and also to enhance the reliability and electrical properties of the semiconductor device.

Although the present disclosure have been described in connection with the some embodiments of the present disclosure illustrated in the accompanying drawings, it will be understood by one of ordinary skill in the art that variations in form and detail may be made therein without departing from the spirit and essential feature of the present disclosure. The above disclosed embodiments should thus be considered illustrative and not restrictive. Moreover, some embodiments of the present disclosure may be combined with each other.

## Claims

1. A semiconductor device, comprising:
an active pattern;
a gate structure that extends in a first direction on the active pattern;
a bit line electrically connected to the active pattern and extending in a second direction that intersects the first direction;
a gate contact electrically connected to the gate structure;
a dummy line between the gate contact and the bit line; and
a dummy dielectric layer at least partially surrounded by the dummy line,
wherein the dummy line comprises:
a first dummy line part between the dummy dielectric layer and the bit line;
a second dummy line part spaced apart from the first dummy line part; and
a plurality of connection parts that electrically connect the first and second dummy line parts to each other, and
wherein the dummy dielectric layer is between the first dummy line part and the second dummy line part and is between the plurality of connection parts.

2. The semiconductor device of claim 1, further comprising a dielectric fence between the first dummy line part and the bit line, wherein a width of the dielectric fence in the second direction is less than a width of the dummy dielectric layer in the second direction.

3. The semiconductor device of claim 2, wherein:
the gate structure comprises a gate electrode layer and a gate capping layer on the gate electrode layer, and
the dielectric fence and the dummy dielectric layer contact the gate capping layer.

4. The semiconductor device of claim 1, wherein:
the gate structure comprises a plurality of gate structures, and
the dummy dielectric layer overlaps the plurality of gate structures in a third direction that intersects the first direction and the second direction.

5. The semiconductor device of claim 1, further comprising a dummy line capping layer on the dummy line, wherein the dummy line capping layer at least partially surrounds the dummy dielectric layer.

6. The semiconductor device of claim 1, wherein a width of the first dummy line part in the first direction is the same as a width of the bit line in the first direction.

7. The semiconductor device of claim 1, wherein a width of the first dummy line part in the first direction is less than a width of the second dummy line part in the first direction.

8. The semiconductor device of claim 1, further comprising:
a first outer dummy spacer that contacts a first outer sidewall of the dummy line;
a second outer dummy spacer that contacts a second outer sidewall of the dummy line; and
an inner dummy spacer that contacts inner sidewalls of the dummy line,
wherein the inner dummy spacer is between the first outer dummy spacer and the second outer dummy spacer.

9. The semiconductor device of claim 8, wherein the inner dummy spacer comprises:
a plurality of first parts that extend in the first direction; and
a plurality of second parts that extend in the second direction intersecting the first direction,
wherein the plurality of first parts of the inner dummy spacer are spaced apart from each other in the second direction,
wherein the plurality of second parts of the inner dummy spacer are spaced apart from each other in the first direction, and
wherein one of the plurality of first parts of the inner dummy spacer contacts respective ones of the second parts of the inner dummy spacer.

10. The semiconductor device of claim 9, wherein a length of each of the first parts of the inner dummy spacer in the first direction is less than a length of each of the second parts of the inner dummy spacer in the second direction.

11. The semiconductor device of claim 8, wherein:
the first dummy line part is between the first outer dummy spacer and the inner dummy spacer,
the second dummy line part is between the second outer dummy spacer and the inner dummy spacer, and
the plurality of connection parts are between the first outer dummy spacer and the second outer dummy spacer.

12. The semiconductor device of claim 1, wherein:
the first dummy line part and the second dummy line part are spaced apart from each other in the first direction, and
a sum of a width of the first dummy line part in the first direction and a width in the first direction of the second dummy line part is less than a width of one of plurality of the connection parts in the first direction.

13. The semiconductor device of claim 1, wherein a distance between the first dummy line part and the bit line is greater than a distance between the plurality of connection parts and the bit line.

14. The semiconductor device of claim 1, further comprising a dummy dielectric pattern on the gate structure, wherein:
a bottom surface of the dummy line contacts a top surface of the dummy dielectric pattern, and
the dummy dielectric layer extends into the dummy dielectric pattern and contacts the gate structure.

15. The semiconductor device of claim 14, wherein the dummy dielectric pattern at least partially surrounds the dummy dielectric layer.
